# EUROPÄISCHE PATENTSCHRIFT

(11) **EP 2 830 813 B1**
(45) Veröffentlichungstag und Bekanntmachung des Hinweises auf die Patenterteilung: **04.05.2016**
(21) Anmeldenummer: 13719005.4
(22) Anmeldetag: 11.03.2013
(51) Int. Cl.: B23K 15/00, G01T 1/29, H01J 37/244, H01J 37/31

(54) **VERFAHREN ZUR ERMITTLUNG VON STRAHLPARAMETERN EINES LADUNGSTRÄGERSTRAHLS, MESSEINRICHTUNG SOWIE LADUNGSTRÄGERSTRAHLVORRICHTUNG MIT SOLCHER MESSEINRICHTUNG**
METHOD OF DETERMINING BEAM PARAMETERS OF A CHARGE CARRIER BEAM, MEASURING DEVICE, AND CHARGE CARRIER BEAM DEVICE WITH SUCH MEASURING DEVICE
PROCÉDÉ DE DÉTERMINATION DES PARAMÈTRES D'UN FAISCEAU DE PORTEURS DE CHARGE, DISPOSITIF DE MESURE ET DISPOSITIF À FAISCEAU DE PORTEURS DE CHARGE AVEC UN TEL DISPOSITIF DE MESURE

(30) Priorität: 27.03.2012 DE 102012102608
(43) Veröffentlichungstag der Anmeldung: 04.02.2015
(73) Patentinhaber: RWTH Aachen - Körperschaft des öffentlichen Rechts, 52062 Aachen (DE); Aixacct Systems GmbH, 52068 Aachen (DE)
(72) Erfinder: REISGEN, Uwe, 52249 Eschweiler (DE); DE VRIES, Jens, 52249 Eschweiler (DE); BACKHAUS, Alexander, 52062 Aachen (DE); BAUER, Hans-Peter, B-4731 Eynatten (BE); UFER, Sebastian, 52064 Aachen (DE); REICHENBERG, Bernd, 52146 Würselen (DE); SCHMITZ-KEMPEN, Thorsten, 52074 Aachen (DE)
(74) Vertreter: Naeven, Ralf
(86) Internationale Anmeldenummer: PCT/DE2013/100091
(87) Internationale Veröffentlichungsnummer: WO 2013/143531

(56) Entgegenhaltungen:
- US-A1- 2010 032 562
- US-A1- 2010 258 719
- US-B2- 7 348 568

## Beschreibung

Die Erfindung betrifft ein Verfahren zur Ermittlung von Strahlparametern eines Ladungsträgerstrahls gemäß dem Oberbegriff des Anspruchs 1, eine Messeinrichtung gemäß dem Oberbegriff des Anspruchs 10 sowie eine Ladungsträgerstrahlvorrichtung gemäß dem Oberbegriff des Anspruchs 16 (siehe, z.B., US 7 348 568).

Ein Ladungsträgerstrahl, z. B ein Elektronenstrahl, kann zur Materialbearbeitung, z. B. in Schweiß- und Schneideprozessen, zum Bohren, Abtragen und in weiteren Formen der geometrischen oder metallurgischen Oberflächenbearbeitung eingesetzt werden. Die Qualität des Bearbeitungsergebnisses hängt dabei in entscheidendem Maße von den Eigenschaften des Ladungsträgerstrahls ab. Es besteht daher ein großes Interesse daran, die Eigenschaften des einzusetzenden Ladungsträgerstrahls möglichst hochgenau bestimmen zu können. Insbesondere interessieren die Strahlgeometrie mit Intensitätsverteilung, die Strahlkaustik und die Lage des Fokuspunktes.

Es ist bekannt (Reisgen, Uwe; Olschok, Simon; Backhaus, Alexander: "Diabeam: Ein vielseitiges Werkzeug zur Vermessung des Elektronenstrahls"; Im Blickpunkt - Deutschlands elite-Institute: Institut für Schweißtechnik und Fügetechnik der RWTH Aachen; S 46 - 48; Institut für Wissenschaftliche Veröffentlichungen; ISSN 1614-8185), den zu vermessenden Ladungsträgerstrahl über eine Blendenvorrichtung auf einen Strahlsensor zu richten. Als Blende kann demnach eine Schlitzblende oder eine Lochblende verwendet werden.

Überstreicht der Ladungsträgerstrahl die in einer bekannten Position und Ausrichtung befindliche Schlitzblende quer zu seiner Längsausrichtung, wird mittels des Strahlsensors eine eindimensionale Vermessung des Strahls ermöglicht. Für die vollständige Charakterisierung des Strahls wird eine Rotationssymmetrie des Strahlquerschnitts angenommen.

Eine genauere Vermessung des Strahlquerschnitts ist mittels der Lochblende möglich. Dabei überstreicht der Ladungsträgerstrahl zeilenweise mit zum Beispiel 50 bis 100 Zeilen die Lochblende. Mit einer Lochblende eines Durchmessers von z. B. 20 µm kann der einen Durchmesser von etwa 100-200 µm aufweisende Strahlquerschnitt hochgenau zweidimensional vermessen werden. In der Praxis hat es sich bislang jedoch als problematisch herausgestellt, die Lochblende mit dem Ladungsträgerstrahl zu treffen. Manuell durchgeführte zeitaufwändige Justagen sind dabei die Regel.

Weiterhin sind Blendenvorrichtungen bekannt (Dilthey, U.; Böhm, S.; Welters, T.; Rößler, K.; Manoharan, S.; Buvanashekaran, G.: "Electron beam measurements with a diabeam system as a tool for the quality assurance", Proceedings: SOJOM 2000: Symposium on Joinig of Materials, 20.-22. Januar, 2000, Tiruchirappalli, India), die zwei zueinander parallele Schlitzblenden und zusätzlich eine Lochblende aufweisen. Eine der Schlitzblenden wird in der Strahlmittelachse des nicht abgelenkten Elektronenstrahls über einem Strahlsensor angeordnet und wird zur eigentlichen eindimensionalen Strahlparametermessung eingesetzt. Die zweite Schlitzblende dient dazu, die Ablenkgeschwindigkeit des über beide Schlitze oszillierenden Elektronenstrahls zu bestimmen. Der Lochsensor kann zur genaueren zweidimensionalen und zeitintensiveren Bestimmung der Strahlparameter eingesetzt werden. Schlitzblendenmessung und Lochblendenmessung sind unabhängig voneinander.

Des Weiteren werden eine Blendenvorrichtung mit zwei zueinander parallelen Schlitzblenden und einer Lochblende sowie ein Verfahren zum Diagnostizieren eines Elektronenstrahls im Aufsatz "Electron beam diagnostics: A new release of the diabeam system" (U. Dilthey et al, Vacuum, 62 (2001), 77 bis 85) näher dargestellt. Aussagen zur automatischen Justage der Lochblende sind nicht gemacht.

Aus der US 5,382,895 ist ein Verfahren zur Strahldiagnose mittels einer Schlitzblende bekannt. Dabei wird der Ladungsträgerstrahl auf einen einzelnen Schlitz gerichtet und der hindurchgehende Ladungsstrahl festgestellt. Hiernach wird der Schlitz gedreht und eine erneute Messung durchgeführt. Aus einer Vielzahl von einzelnen Messungen wird in tomographischer Weise das Intensitätsprofil des Strahls ermittelt. Die Justierung des Messsystems erfolgt dabei manuell.

Des Weiteren ist es bekannt (E. Koleva et al, "Emittance Calculation Based on the Current Distribution Measurements at Changes of the Beam Focusing", Proceedings at the 8th International Conference on Electron Beam Technologies, Varna (2006), 51-65), zur Strahlcharakterisierung eine Blendenvorrichtung mit zwei senkrecht zueinander stehenden Schlitzblenden zu verwenden. Es erfolgen dabei zwei Messungen, die jeweils mit einer Strahlführung senkrecht zu jedem der beiden Schlitzblenden verläuft. Eine zu justierende Lochblende wird nicht eingesetzt.

Des weiteren ist es bekannt (US 7,348,568) eine Blende mit strahlartig radial verlaufenden Schlitzen zu verwenden, wobei der Ladungsträgerstrahl auf einer Kreisbahn senkrecht zu den Schlitzen geführt wird. Die Auswertung der einzelnen Messvorgänge kann ebenfalls tomographisch erfolgen und zu einem Intensitätsprofil des Strahls führen. Eine Justierung der Messapparatur ist nicht angesprochen.

Zur Messung der radialen Stromverteilung in einem Elektronenstrahl ist es des Weiteren bekannt (S. Wójcicki et al), zwei mit Schlitzblenden versehene Platten in Strahlrichtung hintereinander anzuordnen. Die Schlitzblenden sind geradlinig und rechtwinklig zueinander. Des Weiteren ist jede Schlitzblende senkrecht zu der von der Schlitzblende während der Messung durchgeführten Bewegung. Der Einsatz einer Lochblende und deren Ausrichtung zum Strahl sind nicht angesprochen.

Für die Messung der Emittanz eines Elektronenstrahls ist es bekannt (K. Friedel et al), eine Lochblende in Strahlrichtung vor einer Schlitzblende einzusetzen. Eine automatische Justierung der Lochblende im Elektronenstrahl ist nicht angesprochen.

Aus der DE 102 32 230 A1 ist ein Verfahren zur Vermessung des Intensitätsprofils eines Elektronenstrahls bekannt, welches auch eine Justierung einer Optik für einen Elektronenstrahl erwähnt. Dabei wird der Elektronenstrahl auf eine Grafitplatte gelenkt und ein Strom von Rückstreuelektronen mittels eines im Bereich der Ablenkeinheit angeordneten Sensorrings in Abhängigkeit von der Relativbewegung von Elektronenstrahl und Messstruktur gemessen. Ein vor der Strahlvermessung stattfindender Justierprozess selbst wird nicht dargestellt. Der Ladungsträgerstrahl wird auch nicht durch eine Lochblende oder Schlitzblende hindurch auf den Strahlsensor gerichtet.

Die DD 206 960 offenbart ein Verfahren zur Zentrierung von Ladungsträgerstrahlen, bei dem ein Materialblock mit einem Kreuzspalt verwendet wird. Der Ladungsträgerstrahl trifft in einer Kreisbewegung die Spalte des Kreuzspalts überstreichend auf diesen Block. Mittels eines Kreisringauffängers wird ein Elektronenrückstreustrom detektiert. Dieser Rückstreustrom ist abhängig von der Lage des Kreuzspaltes relativ zum Kreis der Strahlbewegung, wodurch eine Zentrierung festgestellt werden kann.

Aus der DE 34 42 207 A1 ist eine Einrichtung zum Erkennen der Auftreffstelle eines Ladungsträgerstrahls auf einem Target bekannt. Dabei werden die von der Auftreffstelle ausgehenden Röntgenstrahlen mittels eines Detektors erkannt, dessen Signale einer Auswerteschaltung zugeführt werden. Es ist offenbart, die Röntgenstrahlung durch geradlinige Schlitzblenden oder durch eine Lochblende zu führen. Eine Schlitzblende für den Ladungsträgerstrahl ist nicht offenbart.

Die DE 26 34 341 A1 offenbart die Justierung eines Ladungsträgerstrahls bezüglich einer Stoßfuge beim Schweißvorgang. Mittels zweier Sensoren wird eine durch einen oszillierenden Ladungsträgerstrahl erzeugte Rückstreuung festgestellt, wobei das Signalmuster davon abhängt, wie der Mittelgang des Ladungsträgerstrahls zur Stoßfuge positioniert ist. Aus dem Messergebnis kann eine Korrektur erfolgen.

Die DD 226 428 A1 offenbart eine Einrichtung zur Einstellung einer Elektronensonde mittels eines maskierten Elektronendetektors. Die Maske (Blende) weist eine Mehrzahl quadratischer Öffnungen auf. Der Elektronenstrahl wird kreuzförmig geführt und tritt durch die Öffnung hindurch auf einen Strahlsensor. Aus der relativen Lage der durch den Elektronenstrahl gebildeten Kreuzfigur zu der jeweils bestrahlten Öffnung ergibt sich eine Möglichkeit der Ermittlung der Brennfleck- und ablenkbezogenen Parameter der Elektronenstrahlvorrichtung.

Eine automatische Strahljustierung ist des Weiteren von E. Koleva et al offenbart (E. Koleva et al., Emittance Calculation Based on the Current Distribution Measurements at Changes of the Beam Focusing, Proceedings of the 8th International Conference on Electron Beam Technologies, Varna (2006), 51-65), wobei zum einen offenbart wird, von dem zu schweißenden Werkstück ein elektronenoptisches Bild zu erzeugen und mittels Bildverarbeitung die Position und Ausrichtung des Werkstückes zu ermitteln und der CNC-Steuerung zugrunde zu legen. Des Weiteren wird für die automatische Strahlausrichtung für den Schweißprozess vorgeschlagen, den Elektronenstrahl auf einem Sensor mit wechselnden Fokuslängen der Objektivlinse zu vermessen. Dabei werden als Schritte vorgeschlagen, zu fokussieren, dann zunächst grob zu zentrieren und grob zu stigmatisieren und anschließend eine genauere Zentrierung und genauere Stigmatisierung durchzuführen. Der Einsatz von Loch- oder Schlitzblenden und die automatische Ausrichtung der Lochblende zum Elektronenstrahl sind nicht angesprochen.

Der Erfindung liegt das technische Problem zu Grunde, ein Verfahren zur Ermittlung von Strahlparametern eines Ladungsträgerstrahls, eine Messeinrichtung sowie eine Ladungsträgerstrahlvorrichtung der eingangs genannten Art zur Verfügung zu stellen, die eine im Vergleich zum Stand der Technik alternative automatische Selbstjustage einer Messblende ermöglicht.

Bei einem Verfahren zur Ermittlung von Strahlparametern eines Ladungsträgerstrahls wird das technische Problem mit den Merkmalen des Anspruchs 1 gelöst. Bevorzugte Ausführungsformen dieses Verfahrens ergeben sich aus den Unteransprüchen 2 bis 9.

Bei einem zum Einsatz in dem vorgenannten Verfahren geeigneten Messeinrichtung der eingangs genannten Art wird das technische Problem gelöst durch die kennzeichnenden Merkmale des Anspruchs 10. Vorteilhafte Ausbildungsformen der erfindungsgemäßen Messeinrichtung sind in den Ansprüchen 11 bis 15 definiert.

Bei einer Ladungsträgerstrahlvorrichtung der eingangs genannten Art wird das technische Problem durch das kennzeichnende Merkmal des Anspruchs 16 gelöst. Eine vorteilhafte Ausbildungsform der erfindungsgemäßen Ladungsträgerstrahlvorrichtung ergibt sich aus Anspruch 17.

Bei dem erfindungsgemäßen Verfahren zur Ermittlung von Strahlparametern eines Ladungsträgerstrahls wird eine Blendenvorrichtung eingesetzt, die sowohl eine Messbtende in Form einer Lochblende, als auch eine Schlitzblendenanordnung mit einer oder mehreren Schlitzblenden aufweist. Die Schlitzblenden dienen dazu, mit Hilfe des Ladungsträgerstrahls die Position der Blendenvorrichtung bezogen auf eine durch einen Strahlsensor definierte Messebene relativ zu einem Messreferenzpunkt festzustellen.

Der Messreferenzpunkt ist vorzugsweise der Ort in der Messebene, in dem später die Messung der Strahlparameter über die Messblende erfolgt. In der Regel wird hierfür der Schnittpunkt der Strahlmittelachse des nicht abgelenkten Ladungsträgerstrahls mit der Messebene herangezogen. Strahlparametermessungen können auch in anderen Messreferenzpunkten sinnvoll sein, z.B. um die Abhängigkeit der Strahlparameter vom Auslenkungswinkel des Ladungsträgerstrahls zu ermitteln.

Ist die Position der Blendenvorrichtung relativ zum Messreferenzpunkt eindeutig feststellbar, kann die Messblende mit der Blendenvorrichtung automatisch und maschinengesteuert genau oberhalb des Messreferenzpunktes platziert werden, um anschließend die Strahlparametermessung durchzuführen. Somit kann die Messblende für die Strahlparametermessung vollautomatisch justiert werden, wodurch der im Stand der Technik bekannte, in der Regel zeitaufwändigere manuelle Justageakt unterbleiben kann.

Zur Ermittlung der Position der Blendenvorrichtung relativ zum Messreferenzpunkt wird der Ladungsträgerstrahl je nach Geometrie und/oder Position der Schlitzblendenanordnung einmal oder mehrfach über die Schlitzblendenanordnung geführt, wobei die Messebenen-Koordinaten von Strahlauftrefforten der durch die Schlitzblendenanordnung hindurch auf die Messebene auftreffenden Strahlanteile des Ladungsträgerstrahls erfasst werden. Je nach Geometrie der Schlitzblendenanordnung können drei Strahlauftrefforte genügen, um die Position der Blendenvorrichtung relativ zum Messreferenzpunkt eindeutig festzulegen.

Die notwendige Anzahl der Strahlauftrefforte kann bei geeigneter Geometrie mit einem einmaligen Überstreichen der Schlitzblendenanordnung mit dem Ladungsträgerstrahl erreicht werden.

Im Sinne der hier betroffenen Erfindung umfassen die Begriffe des einmaligen Überstreichens der Schlitzblendenanordnung mit dem Ladungsträgerstrahl oder des einmaligen Führens des Ladungsträgerstrahls über die Schlitzblendenanordnung sowohl das einmalige Verfahren des Ladungsträgerstrahls über die Schlitzblendenanordnung in eine Richtung als auch das oszillierende Verfahren, sofern die Ausrichtung der Oszillationsbewegung relativ zur Schlitzblendenanordnung nicht geändert wird.

Das einmalige oder oszillierende Überstreichen der Schlitzblendenanordnung erfolgt bevorzugt geradlinig.

Das erfindungsgemäße Verfahren kann auch so durchgeführt werden, dass zur Erzeugung einer hinreichenden Anzahl von Strahlauftrefforten der Ladungsträgerstrahl mehrfach in unterschiedlichen Orientierungen oder Positionen relativ zur Schlitzblendenanordnung über diese geführt wird, z. B. weil ansonsten die Anzahl der Strahlauftrefforte nicht hinreichend ist.

Das erfindungsgemäße Verfahren kann auch so durchgeführt werden, dass der Ladungsträgerstrahl in zwei voneinander unabhängigen Ablenkrichtungen der Ablenkeinheit über die Schlitzblendenanordnung geführt wird. Die Ablenkeinheit einer Ladungsträgerstrahlvorrichtung weist für zwei unterschiedliche, vorzugsweise aufeinander senkrecht stehende Ablenkrichtungen eigene Ablenkelemente auf, z.B. induktive Elemente, wie Spulen, zur Erzeugung jeweils eines Magnetfeldes oder jeweils ein elektrisches Feld erzeugende Elemente, z.B. Plattenkondensatoren. Die beiden Ablenkrichtungen können zum Beispiel parallel zur X-Achse und zur Y-Achse eines kartesischen Koordinatensystems gewählt werden. Wird der Ladungsträgerstrahl zuerst in der ersten Richtung (z. B. X-Richtung) über die Schlitzblendenanordnung geführt und anschließend in der hierzu senkrechten Richtung (y-Richtung) ist jeweils ein Ablenkelement nicht aktiv, d. h. z. B. die Spule ist stromlos. Beim Überstreichen der Blendenvorrichtung in X-Richtung weisen die aufgefundenen Strahlauftrefforte somit als Y-Komponente diejenige des nicht abgelenkten Ladungsträgerstrahls auf. Beim Überstreichen der Blendenvorrichtung in Y-Richtung ergibt sich entsprechend die X-Koordinate des nicht abgelenkten Ladungsträgerstrahls. Auf diese Weise kann der Schnittpunkt der Strahlmittelachse des nicht abgelenkten Ladungsträgerstrahls mit der Messebene automatisch ermittelt werden. Der Schnittpunkt der Strahlmittelachse des nicht ausgelenkten Ladungsträgerstrahls mit der Messebene kann als Ursprung des kartesischen Koordinatensystems definiert werden.

Um eine hinreichende Anzahl von Strahlauftrefforten zu erhalten, kann das erfindungsgemäße Verfahren auch so ausgeführt werden, dass die Position und/oder die Ausrichtung der Blendenvorrichtung bezogen auf die Messebene mindestens einmal definiert verändert wird, in mindestens zwei unterschiedlichen Positionen und/oder Ausrichtungen der Blendenvorrichtung der Ladungsträgerstrahl oszillierend oder nicht oszillierend über die Schlitzblendenanordnung geführt wird und die Messebenen-Koordinaten mindestens eines Strahlauftreffortes erfasst werden. Die zwischenzeitliche Veränderung der Position und/oder der Ausrichtung der Blendenvorrichtung macht es erforderlich, die sich hieraus ergebenden Bewegungsinformationen als weitere Daten für die Ermittlung von Steuerungsdaten für das Verfahren der Messblende in die Position über dem Messreferenzpunkt zu berücksichtigen. Die Veränderung der Position und/oder Ausrichtung der Blendenvorrichtung kann über eine Translationsbewegung und/oder eine Rotationsbewegung um eine zur Messebene senkrechte Achse durchgeführt werden.

Das erfindungsgemäße Verfahren kann auch so ausgeführt werden, dass die erfassten Messebenen-Koordinaten der Strahlauftrefforte zu Ermittlung mindestens eines Kalibrierwertes der Strahlablenkeinheit verwendet werden. Hierzu wird zu dem Zeitpunkt, zu dem der Ladungsträgerstrahl die Schlitzblende trifft und die Messebenen-Koordinaten des entsprechenden Strahlauftreffortes festgestellt werden, eine relevante Steuergröße für das aktive Ablenkelement der Ablenkeinheit, z. B. der Strom einer Ablenkspule oder die Spannung eines ein elektrisches Feld erzeugenden Elements, erfasst. Bei bekannter Schnittstelle der Strahlmittelachse des unausgelenkten Ladungsträgerstrahls ergibt sich der Kalibrierwert unmittelbar, d. h. eine eindeutige Beziehung zwischen der Auslenkung des Ladungsträgerstrahls, z.B. gemessen in Winkeleinheiten zur nicht ausgelenkten Strahlmittelachse oder in Streckeneinheiten auf der Messebene, und der Ablenksteuergröße, z. B. dem Strom in der Spule oder der Spannung in einem ein elektrisches Ablenkfeld erzeugenden Element.

In der dargestellten Art und Weise kann also der Kalibrierwert einer Ladungsträgerstrahlvorrichtung auch unabhängig von einer späteren Messung an der Messblende festgestellt werden.

Das erfindungsgemäße Verfahren kann auch so ausgeführt werden, dass zur Überprüfung weiterer Strahlparameter, insbesondere einer Winkelabweichung des auf den Messreferenzpunkt gerichteten Ladungsträgerstrahls und/oder der Fokuslage, die Messblende mit einer zur Messebene senkrechten Komponente verfahren wird. Im Falle der Messung am nicht ausgelenkten Ladungsträgerstrahl wird die Blendenvorrichtung in z-Richtung, also senkrecht zur Messebene verfahren. Für die Bewegung in z-Richtung kann die Messblende gemeinsam mit dem Strahlsensor verfahren werden. Es ist aber auch denkbar, die Messblende relativ zum Strahlsensor zu verfahren.

Weiterhin kann es vorteilhaft sein, die mittels der Messung ermittelten Strahlparameter für eine Steuerung oder Regelung der Ladungsträgerstrahlvorrichtung zu verwenden. Die ermittelten Strahlparameter können z.B. in die Steuerung für eine Strahlerzeugungseinheit der Ladungsträgerstrahlvorrichtung rückgekoppelt werden, z.B. zur Steuerung der eingesetzten Spannung oder für eine Manipulation der Position eines Ladungsträgeremittenten, z.B. einer Glühwendel. Die ermittelten Strahlparameter können auch für die Steuerung oder Regelung der Strahlführung und/oder Strahlformung eingesetzt werden, z.B. für eine Fokussiereinheit, eine Justiereinheit, die Ablenkeinheit und/oder einen Stigmator. Anhand hinterlegter Kennlinien können z.B. Strahljustage und Strahlstigmatisierung automatisch durchgeführt werden.

Für die Schlitzblendenanordnung sind unterschiedliche Geometrien denkbar, die die dargestellte automatische Justierung erlauben. So können zwei nicht parallele nebeneinander liegende Schlitzblendenabschnitte mit einer sinnvollen Längserstreckung genügen. Unterschiedliche Schlitzblendenabschnitte können zu einer gemeinsamen Schlitzblende, z.B. mit mäanderförmigem Verlauf, gehören oder aber zu getrennten Schlitzblenden.

Es kann aber auch vorteilhaft sein, eine in sich geschlossene oder weitgehend geschlossene Schlitzblende vorzusehen, z. B. in einer Dreieckform. Die geschlossene, d. h. endlose Schlitzblende erhöht die Wahrscheinlichkeit, dass ein über die Schlitzblende geführter Ladungsträgerstrahl den Schlitz der Schlitzblende zweimal trifft.

Eine besonders bevorzugte Ausbildungsform der Messeinrichtung weist eine Blendenvorrichtung mit einer geschlossenen kreisförmigen Schlitzblende als Schlitzblendenanordnung auf. Diese rotationssymmetrische Schlitzblende erlaubt ein besonders einfaches Berechnen der Position und Anordnung der Blendenvorrichtung bezogen auf die Messebene.

Alternativ können auch Schlitzblenden vorgesehen werden, die geschlossen oder offen halbkreiskreisförmig oder weitgehend kreisförmig mit Unterbrechung(en) des Blendenschlitzes sind.

In einer Messeinrichtung kann auch eine Temperaturüberwachung integriert sein. Dadurch ist es möglich, Messfehler, die aus thermischer Dehnung der Vorrichtung resultieren, mittels der bekannten Materialkennwerte rechnerisch zu korrigieren. Zudem lassen sich durch Temperaturüberwachung Beschädigungen an der Messvorrichtung vorbeugen.

Der von der Blendenvorrichtung abgedeckte Strahlsensor kann durch einen an der Messeinrichtung angeordneten Schutzverschluss vor Verschmutzung bei Nichtbetrieb geschützt werden. Insbesondere der so geschützte Sensor kann permanent in einer Ladungsträgervorrichtung verbleiben, was die Reproduzierbarkeit und Genauigkeit von Messergebnissen erhöhen kann sowie den effektiven Einsatz als Qualitätssicherungsmaßnahme ermöglicht. Der Schutzverschluss kann maschinengesteuert sein.

Des Weiteren kann es vorteilhaft sein, für die Messeinrichtung eine für den Ladungsträgerstrahl geeignete eigene Ablenkeinheit vorzusehen. Diese eigene Ablenkeinheit der Messeinrichtung kann relativ zur Ladungsträgervorrichtung fixiert werden und unabhängig von der Ablenkeinheit der Ladungsträgervorrichtung dessen Ladungsträgerstrahl steuern. Damit kann dieselbe erfindungsgemäße Messeinrichtung autark an verschiedenen Ladungsträgervorrichtungen eingesetzt werden. Die Ablenkeinheit der Ladungsträgervorrichtung braucht nicht eingebunden zu werden und kann während der Strahlparametermessung außer Betrieb bleiben.

Im Folgenden werden anhand von schematischen Figuren ein Ausführungsbeispiel eines erfindungsgemäßen Verfahrens zur Ermittlung von Strahlparametern eines Ladungsträgerstrahls sowie eine bevorzugte Ausbildungsform der erfindungsgemäßen Messeinrichtung dargestellt.

Es zeigt schematisch
- Fig. 1:: eine Elektronenstrahlanlage mit Messeinrichtung zur Strahlparameterbestimmung,
- Fig. 2:: eine Blendenvorrichtung,
- Fig. 3:: eine kreisförmige Schlitzblende in einer Ausgangsposition relativ zu einem Messreferenzpunkt und
- Fig. 4:: die Schlitzblende gemäß Fig. 3 in einer Messposition.

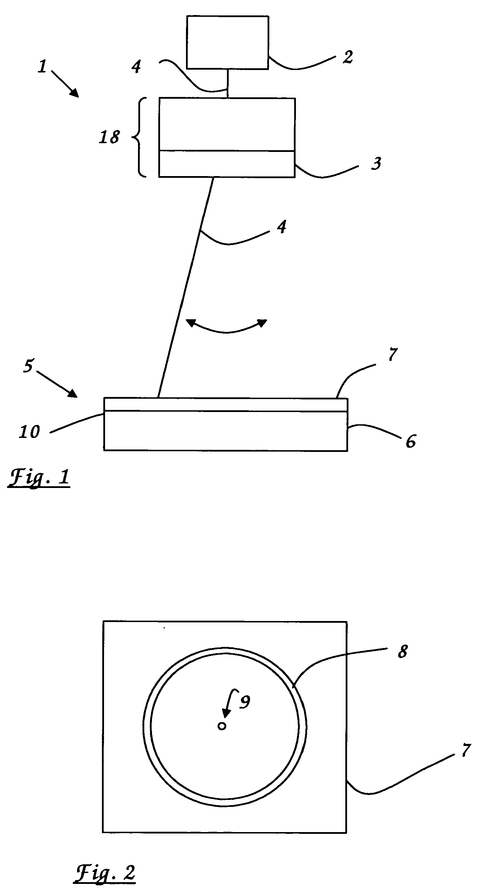

Fig. 1 zeigt eine Elektronenstrahlanlage 1 mit einer Elektronenstrahlerzeugereinheit 2 und einer Strahlmanipulationseinheit 18 zur Strahlführung und Strahlformung. Zur Strahlmanipulationseinheit 18 gehört eine Ablenkeinheit 3, mit der ein Elektronenstrahl 4 aus einer Strahlmittelachse des unausgelenkten Elektronenstrahls 4 abgelenkt wird. Zur Strahlmanipulationseinheit 18 können zudem noch hier nicht dargestellte Einrichtungen für die Fokussierung, Justierung und Stigmatisierung gehören. Die hier nur schematisch dargestellte Ablenkeinheit 3 wird z. B. durch hier nicht gesondert dargestellte Ablenkspulenelemente realisiert, wobei jeweils ein Ablenkspulenelement für eine von zwei unabhängigen Ablenkrichtungen (parallel zu einer x-Achse sowie parallel zu einer y-Achse eines kartesischen Koordinatensystems) verwendet wird. Die Ablenkspulenelemente erzeugen jeweils über einen definierten Stromeintrag ein den Elektronenstrahl 4 ablenkendes Magnetfeld.

Zur Bestimmung von Strahlparametern des Elektronenstrahls 4 wird eine Messeinrichtung 5 eingesetzt, die einen Strahlsensor 6 sowie eine Blendenvorrichtung 7 umfasst. Der Strahlsensor definiert eine Messebene 10, auf die durch die Blendenvorrichtung 7 hindurch getretene Elektronen des Elektronenstrahls 4 auftreffen. Die Blendenvorrichtung 7 ist in Fig. 2 in Aufsicht schematisch dargestellt und weist eine kreisförmige Schlitzblende 8 sowie eine konzentrisch zur Schlitzblende 8 angeordnete Lochblende 9 auf.

Für die Ermittlung der Strahlparameter, z. B. der Verteilung der Intensität im Strahlquerschnitt, wird die Lochblende 9 in bekannter Weise genutzt, indem der Elektronenstrahl 4 zeilenweise über die Lochblende 9 geführt wird.

Bevor die Strahlparametermessung mittels der Lochblende 9 durchgeführt werden kann, ist die Lochblende 9, die zunächst eine Ausgangsposition innehat, die für die Strahlparametermessung nicht geeignet ist, relativ zum Elektronenstrahl 4 zu justieren, d.h. in eine Messposition zu bringen. Diese befindet sich bevorzugt genau in der Strahlmittelachse des nicht abgelenkten Elektronenstrahls 4. Der Schnittpunkt der Strahlmittelachse des nicht abgelenkten Elektronenstrahls 4 mit der Messebene 10 wird im Folgenden Messreferenzpunkt genannt.

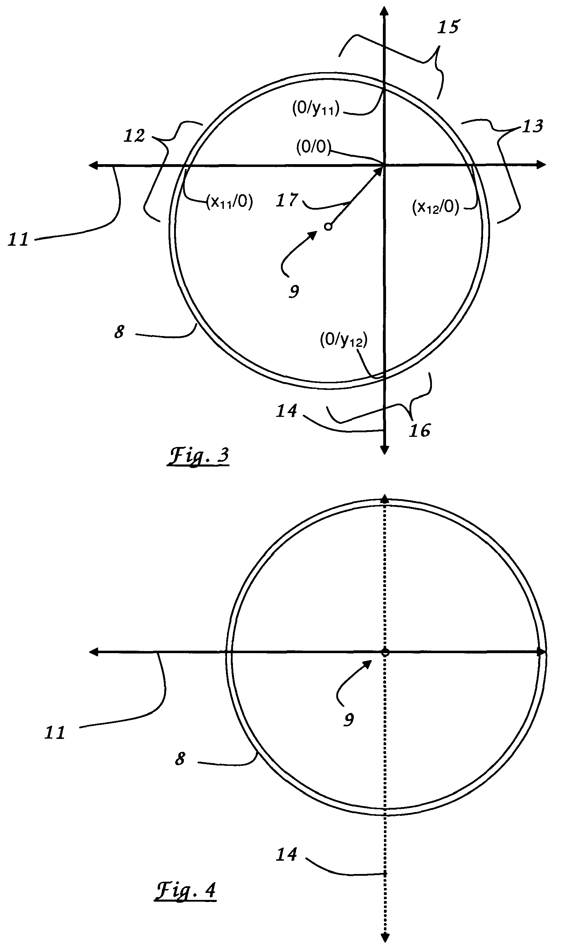

Um die Ausgangsposition der Lochblende 9 relativ zu ihrer Messposition ermitteln zu können, wird zunächst der Elektronenstrahl 4 über die Schlitzblende 8 in definierter Weise oszilliert. Diese Verfahrensweise ist näher in Fig. 3 erläutert. Zunächst wird der Elektronenstrahl 4 allein mittels einer der hier nicht dargestellten Ablenkspulenelemente z. B. in x-Richtung über die Schlitzblende 8 oszilliert. In Fig. 3 ist mittels eines Doppelpfeils die in der Messebene 10 (siehe Fig. 1) oder auf der Blendenvorrichtung 7 gegebene erste Strahlspur 11 des in Fig. 3 nicht dargestellten Elektronenstrahls 4 symbolisiert. In der dazu senkrechten Richtung (im Beispiel die y-Richtung) bleibt der Elektronenstrahl 4 ohne Auslenkung.

Die Messeinrichtung 5 ist derart positioniert, dass der oszillierende Elektronenstrahl 4 die Schlitzblende 8 an zwei unterschiedlichen Schlitzblendenabschnitten 12 und 13 überstreicht. In der unterhalb der Blendenvorrichtung 7 befindlichen Messebene 10 treffen durch die Schlitzblende 8 hindurch tretende Strahlanteile in Strahlauftrefforten auf, deren Koordinaten in der Messebene 10 erfasst werden. Definiert man als Ausgangspunkt des kartesischen Koordinatensystems den Messreferenzpunkt, ergeben sich unterhalb des Schlitzblendenabschnitts 12 als Messebenen-Koordinaten des dortigen Strahlauftrefforts (x₁₁/0) und unterhalb des Schlitzblendenabschnitts 13 (x₁₂/0). Diese Messebenen-Koordinaten sind in Fig. 3 eingetragen, wobei Verschiebungen aufgrund des Abstandes zwischen der Blendenvorrichtung 7 und der Messebene 10 (siehe Fig. 1) vernachlässigt wurden.

Anschließend wird der Elektronenstrahl 4 ohne Auslenkung in x-Richtung entlang der y-Achse oszilliert, was in den Fig. 3 mittels eines weiteren Doppelpfeils als Strahlspur 14 symbolisiert ist. Dabei überstreicht der Elektronenstrahl 4 die Schlitzblende 8 in den Schlitzblendenabschnitten 15 und 16, was in der Messebene 10 zu Strahlauftrefforten mit den Messebenen-Koordinaten (0/y₁₁) und (0/y₁₂) führt.

Bereits mit dreien der vorgenannten Messebenen-Koordinaten ist die Position der kreisförmigen Schlitzblende 8, deren Durchmesser bekannt ist, eindeutig relativ zum Schnittpunkt (0/0) der Strahlmittelachse des unausgelenkten Elektronenstrahls 4 festgelegt. Somit kann auf die Erfassung der Messebenen-Koordinaten des vierten Strahlauftrefforts verzichtet werden. Festgelegt ist damit auch die Position der Lochblende 9, welche im Mittelpunkt des durch die Schlitzblende 8 definierten Kreises angeordneten ist, relativ zum Messreferenzpunkt (0/0). Somit kann mit einfachen geometrischen Berechnungen ein Verfahrweg 17 für die Messeinrichtung 7 ermittelt werden, mit dem die Lochblende 9 maschinengesteuert genau oberhalb des Messreferenzpunktes (0/0) zu platzieren ist. Die Situation mit entsprechend verfahrener Lochblende 9 ist in Fig. 4 dargestellt. In der gegebenen Position der Lochblende 9 kann nun die Strahlparametermessung durchgeführt werden, bei der der Elektronenstrahl in zahlreichen Zeilen, z.B. in x-Richtung, über die Lochblende 9 geführt wird.

Während gemäß Fig. 3 die Position der Blendenvorrichtung 7 relativ zum Messreferenzpunkt (0/0) ermittelt wird, können gleichzeitig die Kalibrierwerte der Ablenkeinheit 3 festgestellt werden. Hierzu wird jeweils zu dem Zeitpunkt, zu dem der Elektronenstrahl 4 durch die Schlitzblende 8 hindurch auf die Messebene 10 tritt, die jeweils zuständige Steuergröße für das für die Oszillationsbewegung zuständige Ablenkspulenelement der Ablenkeinheit 3 notiert, z. B. der eingesetzte Strom. Hierfür genügt grundsätzlich jeweils eines der auf der Strahlspur 11 bzw. 14 ermittelbaren Koordinatenpaare.

Ist die Messvorrichtung 7 bei der Messung gemäß Fig. 3 so platziert, dass die Strahlspuren 11 und 14 die Schlitzblende 8 weniger als dreimal überstreichen, wird die Messvorrichtung 7 in definierter Weise um eine Zwischenstrecke verfahren, um anschließend eine weitere Messung mit der Strahlspur 11 und/oder der Strahlspur 14 durchzuführen. In diesem Fall ist für die Ermittlung des Verfahrwegs 17 der Lochblende 9 zum Messreferenzpunkt die Zwischenstrecke einzubeziehen.

Bei der obigen Betrachtung wurde der vertikale Abstand zwischen Blendenvorrichtung 7 und Messebene 10 vernachlässigt. Dieser ist gegebenenfalls rechnerisch mit einzubeziehen.

### Bezugszeichenliste

- 1: Elektronenstrahlanlage
- 2: Elektronenstrahlerzeugereinheit
- 3: Ablenkeinheit
- 4: Elektronenstrahl
- 5: Messeinrichtung
- 6: Strahlsensor
- 7: Blendenvorrichtung
- 8: Schlitzblende
- 9: Lochblende
- 10: Messebene
- 11: erste Strahlspur (x-Richtung)
- 12: Schlitzblendenabschnitt
- 13: Schlitzblendenabschnitt
- 14: zweite Strahlspur (y-Richtung)
- 15: Schlitzblendenabschnitt
- 16: Schlitzblendenabschnitt
- 17: Verfahrweg zur Messposition
- 18: Strahlmanipulationseinheit

## Patentansprüche

1. Verfahren zur Ermittlung von Strahlparametern eines Ladungsträgerstrahls (4), bei dem
a) der Ladungsträgerstrahl (4) einer Ladungsträgerstrahlvorrichtung (1) mittels einer Strahlablenkeinheit (3) über eine in einer Blendenvorrichtung (7) vorgesehene Schlitzblendenanordnung mit einer oder mehreren Schlitzblenden (8) geführt wird,
b) mittels eines eine Messebene (10) definierenden Strahlsensors (6) Messebenen-Koordinaten von Strahlauftrefforten von durch die Schlitzblendenanordnung hindurch getretenen Strahlanteilen erfasst werden, dadurch gekenzeichnet, dass:
c) eine in der Blendenvorrichtung (7) angeordnete, als Lochblende ausgebildete Messblende (9) automatisch in eine Position über einem in der Messebene (10) gegebenen Messreferenzpunkt verfahren wird, wobei auf der Grundlage der bekannten geometrischen Anordnung der Schlitzblende(n) (8) sowie der Messblende (9) auf der Blendenvorrichtung (7) zur Ermittlung von Steuerungsdaten für das Verfahren der Messblende (9) die Messebenen-Koordinaten der Strahlauftrefforte verarbeitet werden, und
d) der Ladungsträgerstrahl (4) zur Strahlparametermessung über die gemäß Merkmal c) verfahrene Messblende (9) geführt wird.

2. Verfahren nach Anspruch 1, **dadurch gekennzeichnet, dass** zur Durchführung des Verfahrensschritts nach Merkmal a) des Anspruchs 1 der Ladungsträgerstrahl (4) mehrfach über die Schlitzblendenanordnung geführt wird.

3. Verfahren nach Anspruch 2, **dadurch gekennzeichnet, dass** zur Durchführung des Verfahrensschritts nach Merkmal a) des Anspruchs 1 der Ladungsträgerstrahl (4) in zwei voneinander unabhängigen Ablenkrichtungen der Ablenkeinheit (3) über die Schlitzblendenanordnung geführt wird.

4. Verfahren nach einem der vorhergehenden Ansprüche, **dadurch gekennzeichnet, dass** zur Durchführung des Verfahrensschritts nach Merkmal a) des Anspruchs 1 der Ladungsträgerstrahl (4) oszillierend über die Schlitzblendenanordnung geführt wird.

5. Verfahren nach einem der vorhergehenden Ansprüche, **dadurch gekennzeichnet, dass** als Messreferenzpunkt der Auftreffpunkt des unausgelenkten Ladungsträgerstrahls (4) auf der Messebene (10) gewählt wird.

6. Verfahren nach einem der vorhergehenden Ansprüche, **dadurch gekennzeichnet, dass** die Position und/oder die Ausrichtung der Blendenvorrichtung (7) bezogen auf die Messebene (10) mindestens einmal definiert verändert wird, in mindestens zwei unterschiedlichen Positionen und/oder Ausrichtungen der Blendenvorrichtung (7) die Verfahrensschritte gemäß Anspruch 1 Merkmal a) und b) durchgeführt werden und die Veränderung der Position und/oder der Ausrichtung der Blendenvorrichtung (7) als weitere Daten zur Ermittlung von Steuerungsdaten für das Verfahren der Messblende (9) gemäß Verfahrensschritt c) des Anspruchs 1 verarbeitet werden.

7. Verfahren nach einem der vorhergehenden Ansprüche, **dadurch gekennzeichnet, dass** unter Verarbeitung der in Merkmal b) des Anspruchs 1 erfassten Messebenen-Koordinaten der Strahlauftrefforte mindestens ein Kalibrierwert der Strahlablenkeinheit (3) ermittelt wird.

8. Verfahren nach einem der vorhergehenden Ansprüche, **dadurch gekennzeichnet, dass** zur Überprüfung weiterer Strahlparameter, insbesondere einer Winkelabweichung des auf den Strahlreferenzpunkt gerichteten Ladungsträgerstrahls (4) undloder der Fokuslage, die Messblende (9) mit einer zur Messebene 10 senkrechten Komponente verfahren wird.

9. Verfahren nach einem der vorhergehenden Ansprüche, **dadurch gekennzeichnet, dass** die ermittelten Strahlparameter für eine Steuerung oder Regelung der Ladungsträgerstrahlvorrichtung (1) rückgekoppelt werden.

10. Messeinrichtung (5) zur Strahlparametermessung, zum Einsatz in einem Verfahren nach einem der Ansprüche 1 bis 9, umfassend einen Strahlsensor (6) sowie eine Blendenvorrichtung (7), wobei die Blendenvorrichtung (7) eine Schlitzblendenanordnung und eine Messblende (9) aufweist und wobei die Messblende (9) eine Lochblende ist,
**dadurch gekennzeichnet, dass**
die Schlitzblendenanordnung mindestens zwei zueinander nicht parallele Schlitzblendenabschnitte (12, 13, 15, 16) umfasst.

11. Messeinrichtung nach Anspruch 10, **dadurch gekennzeichnet, dass** die zumindest einige der Schlitzblendenabschnitte (12, 13, 15, 16) zu einer einzelnen durchgehenden Schlitzblende (8) gehören.

12. Messeinrichtung nach Anspruch 10 oder 11, **dadurch gekennzeichnet, dass** die Schlitzblendenanordnung eine in sich geschlossene endlose Schlitzblende (8) umfasst.

13. Messeinrichtung nach einem der Ansprüche 10 bis 12, **dadurch gekennzeichnet, dass** die Schlitzblende (8) oder zumindest eine der Schlitzblenden (8) zumindest abschnittsweise kreisförmig ist.

14. Messeinrichtung nach einem der Ansprüche 10 bis 13, **dadurch gekennzeichnet, dass** ein Schutzverschluss zum vorübergehenden Verschließen der Schlitzblendenanordnung und der Messblende (9) vorhanden ist.

15. Messeinrichtung nach einem der Ansprüche 10 bis 14, **gekennzeichnet durch** eine eigene Ablenkeinheit für den Ladungsträgerstrahl (4).

16. Ladungsträgerstrahlvorrichtung zur Durchführung des Verfahrens nach einem der Ansprüche 1 bis 9, umfassend
eine Ladungsträgerstrahlquelle (2) und eine Strahlablenkeinheit (3),
**gekennzeichnet durch**
eine Messeinrichtung (5) nach einem der Ansprüche 10 bis 15.

17. Ladungsträgerstrahlvorrichtung nach Anspruch 16, **gekennzeichnet durch** Mittel zur Rückkopplung von Messergebnissen der Messeinrichtung (5) zur Steuerung der Ladungsträgerstrahlvorrichturtg (1).

## Claims

1. Method for determining beam parameters of a charge carrier beam (4), wherein
a) the charge carrier beam (4) of a charge carrier beam apparatus (1) is guided by means of a beam deflection unit (3) over a slit diaphragm arrangement having one or more slit diaphragms (8), which is provided in a diaphragm apparatus (7),
b) by means of a beam sensor (6) defining a measurement plane (10), measurement plane coordinates of beam impingement locations of beam portions that passed through the slit diaphragm arrangement are detected, **characterized in that**
c) a measurement diaphragm (9) arranged in the diaphragm apparatus (7) and constructed as a pinhole diaphragm is automatically moved into a position above a measurement reference point given in the measurement plane (10), wherein the measurement plane coordinates of the beam impingement locations are processed on the basis of the known geometrical arrangement of the slit diaphragm(s) (8) and the measurement diaphragm (9) on the diaphragm apparatus (7) for the purpose of determining control data for the movement of the measurement diaphragm (9), and
d) the charge carrier beam (4) is guided, for the purpose of beam parameter measurement, over the measurement diaphragm (9) moved in accordance with feature c).

2. Method according to Claim 1, **characterized in that**, for the purpose of carrying out the method step according to feature a) of Claim 1, the charge carrier beam (4) is guided multiply over the slit diaphragm arrangement.

3. Method according to Claim 2, **characterized in that** for the purpose of carrying out the method step according to feature a) of Claim 1, the charge carrier beam (4) is guided over the slit diaphragm arrangement in two mutually independent deflection directions of the deflection unit (3).

4. Method according to any of the preceding claims, **characterized in that**, for the purpose of carrying out the method step according to feature a) of Claim 1, the charge carrier beam (4) is guided over the slit diaphragm arrangement in an oscillating manner.

5. Method according to any of the preceding claims, **characterized in that** the impingement point of the undeflected charge carrier beam (4) on the measurement plane (10) is chosen as the measurement reference point.

6. Method according to any of the preceding claims, **characterized in that** the position and/or the orientation of the diaphragm apparatus (7) relative to the measurement plane (10) are/is altered in a defined manner at least once, the method steps according to Claim 1 features a) and b) are carried out in at least two different positions and/or orientations of the diaphragm apparatus (7) and the alteration of the position and/or the orientation of the diaphragm apparatus (7) is processed as further data for the purpose of determining control data for the movement of the measurement diaphragm (9) according to method step c) of Claim 1.

7. Method according to any of the preceding claims, **characterized in that** at least one calibration value of the beam deflection unit (3) is determined with the processing of the measurement plane coordinates of the beam impingement locations as detected in feature (b) of Claim 1.

8. Method according to any of the preceding claims, **characterized in that**, for the purpose of checking further beam parameters, in particular an angular deviation of the charge carrier beam (4) directed onto the beam reference point, and/or the focal position, the measurement diaphragm (9) is moved with a component perpendicular to the measurement plane (10).

9. Method according to any of the preceding claims, **characterized in that** the beam parameters determined are fed back for a control or regulation of the charge carrier beam apparatus (1).

10. Measuring device (5) for measuring beam parameters suitable for use in a method according to any of Claims 1 to 9, comprising a beam sensor (6) and a diaphragm apparatus (7), wherein the diaphragm apparatus (7) has a slit diaphragm arrangement and a measurement diaphragm (9) and wherein the measurement diaphragm is a pinhole diaphragm,
**characterized in that**
the slit diaphragm arrangement comprises at least two slit diaphragm sections (12, 13, 15, 16) which are not parallel to one another.

11. Measuring device according to Claim 10, **characterized in that** at least some of the slit diaphragm sections (12, 13, 15, 16) belong to an individual continuous slit diaphragm (8).

12. Measuring device according to Claim 10 or 11, **characterized in that** the slit diaphragm arrangement comprises a self-contained endless slit diaphragm (8).

13. Measuring device according to any of Claims 10 to 12, **characterized in that** the slit diaphragm (8) or at least one of the slit diaphragms (8) is circular at least in sections.

14. Measuring device according to any of Claims 10 to 13, **characterized in that** a protective shutter for temporarily closing off the slit diaphragm arrangement and the measurement diaphragm (9) is present.

15. Measuring device according to any of Claims 10 to 14, **characterized by** a dedicated deflection unit for the charge carrier beam (4).

16. Charge carrier beam apparatus for carrying out the method according to any of Claims 1 to 9, comprising a charge carrier beam source (2) and a beam deflection unit (3),
**characterized by**
a measuring device (5) according to any of Claims 10 to 15.

17. Charge carrier beam apparatus according to Claim 16, **characterized by** means for feeding back measurement results of the measuring device (5) for the control of the charge carrier beam apparatus (1).

## Revendications

1. Procédé de détermination de paramètres de faisceau d'un faisceau de porteurs de charge (4), dans lequel :
a) le faisceau de porteurs de charge (4) d'un dispositif à faisceau de porteurs de charge (1) est guidé au moyen d'une unité de déviation de faisceau (3) via un dispositif d'obturation de fente prévu dans un dispositif d'obturation (7) doté d'un ou plusieurs obturateurs de fente (8) ;
b) les coordonnées de plan de mesure des lieux d'incidence du faisceau sont détectées à partir des parties du faisceau traversant le dispositif d'obturation de fente à l'aide d'un détecteur de faisceau (6) définissant un plan de mesure (10) ; **caractérisé en ce que** :
c) un obturateur de mesure (9) disposé dans le dispositif d'obturation (7) et réalisé sous la forme d'un obturateur de trou est déplacé automatiquement dans une position au-dessus d'un point de mesure de référence donné dans le plan de mesure (10), les coordonnées de plan de mesure des lieux d'incidence de faisceau sont traitées sur la base de l'agencement géométrique connu du ou des obturateurs de fente (8) ainsi que de l'obturateur de mesure (9) sur le dispositif d'obturation (7) pour déterminer les données de commande servant à déplacer l'obturateur de mesure (9) ; et
d) le faisceau de porteurs de charge (4) servant à la mesure de paramètre de faisceau est guidé par-dessus l'obturateur de mesure (9) déplacé selon la caractéristique c).

2. Procédé selon la revendication 1, **caractérisé en ce que** pour la mise en oeuvre de l'étape de procédé selon la caractéristique a) de la revendication 1, le faisceau de porteurs de charge (4) est guidé de multiples fois par-dessus le dispositif d'obturation de fente.

3. Procédé selon la revendication 2, **caractérisé en ce que** pour la mise en oeuvre de l'étape de procédé selon la caractéristique a) de la revendication 1, le faisceau de porteurs de charge (4) est guidé dans deux directions de déflexion indépendantes l'une de l'autre de l'unité de déflexion (3) par-dessus le dispositif d'obturation de fente.

4. Procédé selon l'une quelconque des revendications précédentes, **caractérisé en ce que** pour la mise en oeuvre de l'étape de procédé selon la caractéristique a) de la revendication 1, le faisceau de porteurs de charge (4) est guidé de façon oscillante par-dessus le dispositif d'obturation de fente.

5. Procédé selon l'une quelconque des revendications précédentes, **caractérisé en ce que** le point de mesure de référence choisi est le point d'incidence du faisceau de porteurs de charge (4) sur le plan de mesure (10) non dévié.

6. Procédé selon l'une quelconque des revendications précédentes, **caractérisé en ce que** la position et/ou l'orientation du dispositif d'obturation (7) par rapport au plan de mesure (10) est modifiée au moins une fois de façon définie, les étapes de procédé selon la revendication 1 et les caractéristiques a) et b) étant réalisées dans au moins deux positions et/ou orientations différentes du dispositif d'obturation (7) et le changement de la position et/ou de l'orientation du dispositif d'obturation (7) étant traité comme des données supplémentaires pour déterminer les données de commande pour le déplacement de l'obturateur de mesure (9) selon l'étape de procédé c) de la revendication 1.

7. Procédé selon l'une quelconque des revendications précédentes, **caractérisé en ce qu'**au moins une valeur d'étalonnage de l'unité de déviation de faisceau (3) est calculée lors du traitement des coordonnées de plan de mesure des lieux d'incidence de faisceau détectées à la caractéristique b) de la revendication 1.

8. Procédé selon l'une quelconque des revendications précédentes, **caractérisé en ce que** pour vérifier les paramètres de faisceau supplémentaires, notamment un écart angulaire du faisceau de porteurs de charge (4) orienté sur le point de référence de faisceau et/ou la position du point focal, l'obturateur de mesure (9) est déplacé avec une composante perpendiculaire au plan de mesure (10).

9. Procédé selon l'une quelconque des revendications précédentes, **caractérisé en ce que** les paramètres de faisceau calculés sont couplés rétroactivement pour une commande ou un réglage du dispositif à faisceau de porteurs de charge (1).

10. Dispositif de mesure (5) servant à la mesure de paramètre de faisceau à mettre en oeuvre dans un procédé selon l'une quelconque des revendications 1 à 9, comprenant un détecteur de faisceau (6) ainsi qu'un dispositif d'obturation (7), le dispositif d'obturation (7) comportant un dispositif d'obturation de fente et un obturateur de mesure (9) et l'obturateur de mesure (9) étant un obturateur de trou, **caractérisé en ce que** le dispositif d'obturation de fente comprend au moins deux sections d'obturation de fente (12, 13, 15, 16) non parallèles les unes par rapport aux autres.

11. Dispositif de mesure selon la revendication 10, **caractérisé en ce qu'**au moins les quelques sections parmi les sections d'obturation de fente (12, 13, 15, 16) appartiennent à un obturateur de fente (8) continu individuel.

12. Dispositif de mesure selon la revendication 10 ou 11, **caractérisé en ce que** le dispositif d'obturation de fente comprend un obturateur de fente (8) sans fin fermé en soi.

13. Dispositif de mesure selon l'une quelconque des revendications 10 à 12, **caractérisé en ce que** l'obturateur de fente (8) ou au moins un des obturateurs de fente (8) prend au moins en partie une forme de cercle.

14. Dispositif de mesure selon l'une quelconque des revendications 10 à 13, **caractérisé en ce qu'**une fermeture de protection est présente pour fermer temporairement le dispositif d'obturation de fente et l'obturateur de mesure (9).

15. Dispositif de mesure selon l'une quelconque des revendications 10 à 14, **caractérisé par** la présence d'une unité de déflexion propre pour le faisceau de porteurs de charge (4).

16. Dispositif à faisceau de porteurs de charge servant à la mise en oeuvre du procédé selon l'une quelconque des revendications 1 à 9, comprenant une source de faisceau de porteurs de charge (2) et une unité de déviation de faisceau (3), **caractérisé par** un dispositif de mesure (5) selon l'une quelconque des revendications 10 à 15.

17. Dispositif à faisceau de porteurs de charge selon la revendication 16, **caractérisé par** la présence de moyens de contre-réaction aux résultats de mesure du dispositif de mesure (5) pour commander le dispositif à faisceau de porteurs de charge (1).
